# EUROPEAN PATENT APPLICATION

(11) **EP 1 221 428 A2**
(43) Date of publication of application: **10.07.2002**
(21) Application number: 02250033.4
(22) Date of filing: 04.01.2002
(51) Int. Cl.: B81B 7/00, H01L 21/58

(54) **Self-aligned electrical interconnect for two assembled perpendicular semiconductor chips**

(30) Priority: 04.01.2001 US 754940
(71) Applicant: OpticNet, Inc., San Francisco, California 94104 (US)
(72) Inventor: Lim, Martin, San Mateo, CA 94402 (US); Yun, Weijie, San Jose, CA 95120 (US)
(74) Representative: McLeish, Nicholas Alistair Maxwell

(57) **Abstract**

A self-aligned electrical interconnect for two assembled perpendicular semiconductive chips is formed by a slot in a carrier chip having a notch with a metal trace. The other device chip is perpendicularly placed in the slot and has a matching metal trace. The chips are then bonded together by the traces to provide for fine perpendicular alignment of the assembled chips.

## Description

### INTRODUCTION

The present invention is directed to a self-aligned electrical interconnect for two assembled perpendicular semiconductor chips and, more specifically, where such assembly is used in a photonic switch application such as an NxN switching matrix.

### BACKGROUND OF THE INVENTION

As disclosed in a co-pending application entitled FIBER OPTIC SWITCH USING MEMS (micro electromechanical system), filed February 15, 2000, Serial No. 090/504,632, because of the great demand for data centric services brought on by the explosive growth of the Internet, there is a need for all optical switching networks. Such network applications require switching matrices from 8 x 8 to 1024 x 1024. The above pending application provides one technique for providing such a switch including the use of a semiconductor carrier, chip or wafer and vertically erected optical mirrors or switches. In such an assembly, accuracy is of upmost importance in reflecting the laser beam light from one fiber optic line to another and along with that ease of assembly.

### OBJECT AND SUMMARY OF INVENTION

It is a general object of the present invention to provide self-aligned electrical interconnect for two assembled perpendicular semiconductor chips.

In accordance with the above object, there is provided a method of mounting at least one device semiconductor chip carrying an integrated circuit perpendicularly on a carrier semiconductor chip comprising the following steps: forming one or more slots in the carrier chip each with at least one notch having a predetermined width and a metal trace against the far wall of the notch; on the vertical device chip forming a matching metal trace of such width extending from the face of the device chip and connecting to the integrated circuit; placing the device chip in the slot of the carrier chip and fitting the extended metal trace into the notch for an alignment; and bonding the traces together to pull the device chip against a wall of the slot which contains the notch for fine alignment and electrical connection.

A optical matrix switch structure is also provided.

### BRIEF DESCRIPTION OF THE DRAWINGS

FIG. 1 is a perspective view of a simplified form of the assembly of the present invention.
FIG. 2 is a top view of FIG. 1.
FIG. 3 is an enlarged cross-sectional view taken substantially along the line 3-3 of FIG. 2.
FIG. 4 is similar to FIG. 3 showing a step in the method of the present invention.
FIG. 5 is a perspective view of an optical switch embodying the present invention.
FIG. 6 is a flow chart of the method of the present invention.

### DETAILED DESCRIPTION OF PREFERRED EMBODIMENT

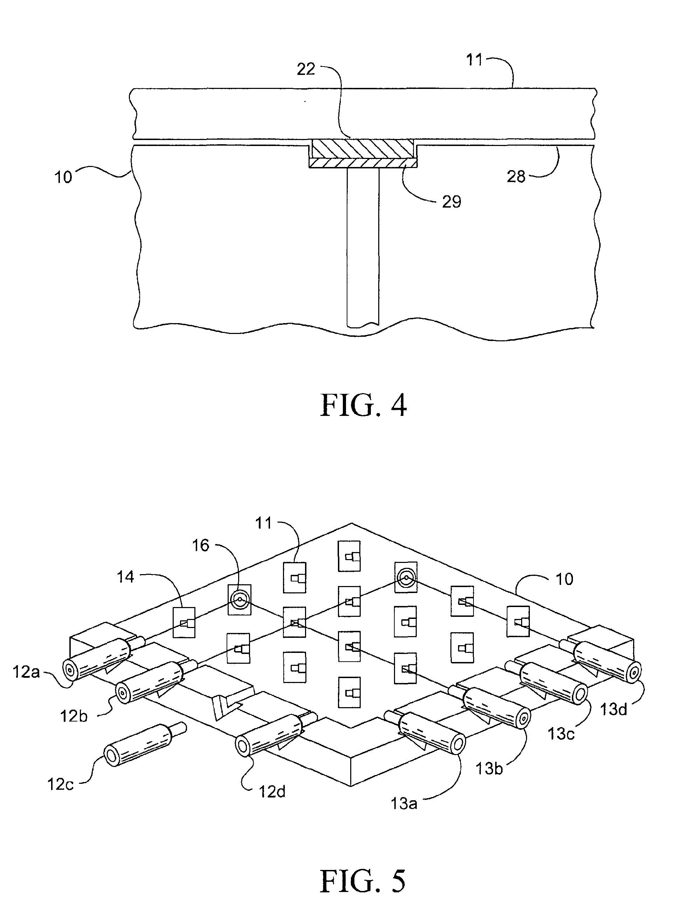

FIG. 5 illustrates a simplified optical matrix switch constructed in accordance with the present invention which is based on micro electromechanical systems (MEMS) and which is also illustrated in the above co-pending application and operates from a switching standpoint in the same manner. Specifically, the switch includes a silicon or other semiconductive substrate wafer 10 on which is placed a matrix of cross-point mirror assemblies 11 which are located at all possible cross-points or intersections of a plurality of input information carrying light beams 12a - 12d and output beams 13a - 13d. Typically, these would be fiber optic lines. From a switching standpoint, this is similar to a mechanical cross-bar switch where it is desired to allow any one selected input 12a - 12d to be connected to any one selected output 13a - 13d. Thus, the cross-point mirror assemblies 11 which are located in every possible switching junction include movable mirrors (as disclosed in the above co-pending application) having a first position where the mirror reflects a selected input beam to provide a selected output beam and a second position where through transmission is allowed. The mirror assemblies 11 are perpendicularly placed on the polished surface of the wafer 10.

Thus, for example, in the case of the input 12a a beam 14 is reflected by a mirror 16 at a right angle and it continues on its path to the output 13b. It is obvious that the alignment of the mirrors is very critical. Also, there is a necessity for electrical interconnection to provide switching of the reflecting mirror surface from one position where through transmission of beam 14 is allowed to where the beam is intercepted and reflected.

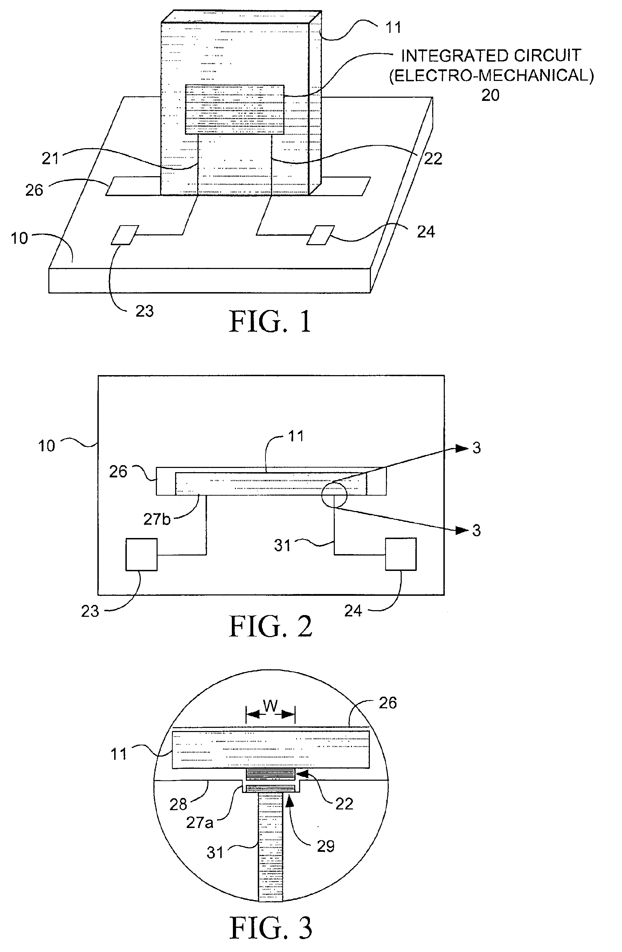

FIG. 1 illustrates one vertical mirror assembly 11 which is perpendicular to the wafer 10. The mirror assembly 11 contains an integrated circuit 21 which may include the electrical mechanical mirror switching as in the above co-pending application. Thus, the mirror assembly 11 is a device semiconductor chip which may or may not have active devices on the chip but includes any type of device fabricated with an integrated circuit process including micro electromechanical system (MEMS) devices. In any case, all of these devices require electrical interconnection indicated by the pair of electrical lines 21 and 22 which must be connected to pads 23 and 24 on wafer 10. Wafer 10 has formed in it a slot 26 which has inserted in it the mirror assembly or device semiconductor chip 11.

FIG. 2 shows this insertion more clearly. FIG. 3 is an enlarged view of a portion of FIG. 2 showing the slot 26 which has a notch 27a in its far wall 28 having a predetermined width, W, and with a metal trace 29 which has been deposited on the far wall of the notch 29 and connects via the circuit trace 31 to pad 24. Such trace can be deposited by any convenient technique such as electroplating, sputtering or evaporation. Also, the metal used may be any suitable conductive metal such as nickel, copper, gold, silver or a gold tin amalgam depending on temperatures to which the integrated circuit or electromechanical circuit 21 may tolerate as will be discussed below. A similar metal trace 22, as shown in FIG. 3, is deposited on the mirror assembly 11 also having a width, W, which extends from the face of the mirror assembly 11. Thus, when the mirror assembly 11 is inserted into the slot 26, the metal trace 22 provides an alignment of mirror assembly 11 in slot 26.

Next, the temperature is raised to the appropriate temperature for a reflow to occur between the metal traces 22 and 29 which results in the final structure of FIG. 4 where the mirror assembly 11 is pulled against a wall 28 of the slot to finely align the mirror assembly 11 with the wafer 10 and also provide an electrical connection. In a typical reflow process, the surface tension of the metal will pull the two metal traces together. Thus, for an alignment the accuracy may be 10 to 50 microns and in the fine alignment there is a 1 micron accuracy. The actual temperature used will vary with the metal used; for example, for nickel-based systems 400°C and for a gold tin mixture 200°C.

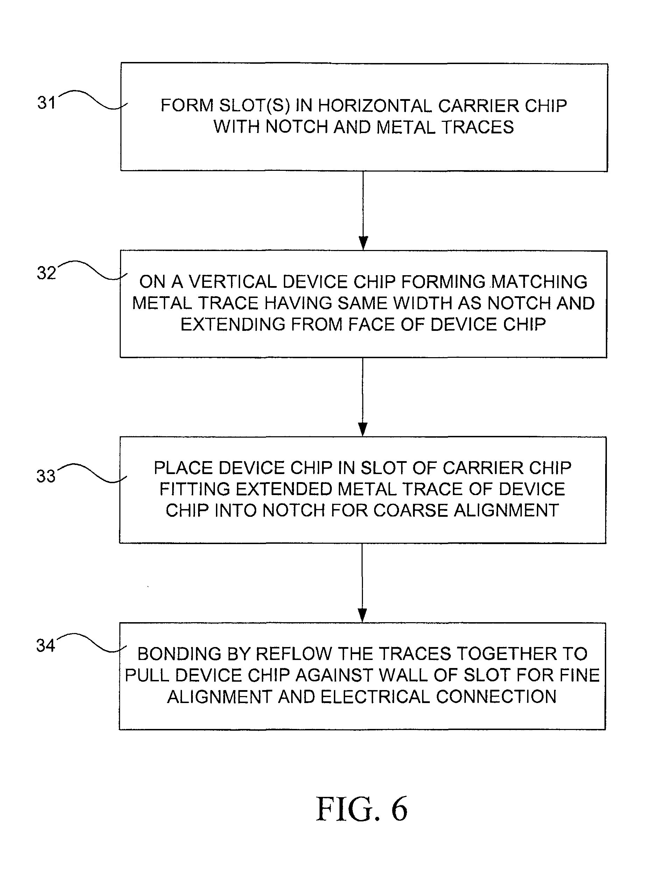

FIG. 6 shows the method of the present invention in simplified process steps where in steps 31 slots are formed in the horizontal carrier chip and the metal traces formed in the notches. In step 32, the vertical device chip or the mirror assembly 11 has formed on it the matching metal traces which extend from the face of the device chip. In step 33, the device chip is placed in the slot of the carrier chip and the notch provides for coarse alignment. Finally, in step 34 bonding by, for example, reflow pulls the device chip against the wall of the slot for fine alignment and electrical connection.

Thus, in summary this present invention provides for a self-alignment assembly of perpendicular chips along with an electrical interconnect. It has a preferred application in an optical switch, although it may be used in other applications.

## Claims

1. A method of mounting at least one device semiconductor chip carrying an integrated circuit perpendicularly on a carrier semiconductor chip comprising the following steps:
forming one or more slots in said carrier chip each with at least one notch having a predetermined width and a metal trace against the far wall of the notch;
on said device chip forming a matching metal trace of said width extending from the face of said device chip and connecting to said integrated circuit;
placing said device chip in said slot of said carrier chip and fitting said extended metal trace into said notch for an alignment;
bonding said traces together to pull said device chip against a wall of said slot which contains said notch for fine alignment and electrical connection.

2. A method as in claim 1 where said device chip includes a movable mirror portion and is a matrix switching point of an optical switch.

3. In an optical matrix switch having a plurality of cross-points for switching a plurality of information carrying light beams between any one of a plurality of input beams to any one of a plurality of output beams by choosing the appropriate cross-point of the matrix,
each cross-point being a micro electromechanical (MEM) type mirror having a first position where said mirror reflects said selected input beam to provide a selected one output beam and a second position where it provides a through path for transmission of said light,
a carrier semiconductor chip for perpendicularly, relative to the surface of the chip, retaining said cross-point mirror said carrier chip having a plurality of slots, each with a notch having a predetermined width and a metal trace against the far wall of the notch, each said perpendicular mirror being inserted in a slot and having a matching metal trace of said width extending from its face into said notch and bonded to said notch to pull said mirror against a wall of said slot whereby said mirror is finally aligned in said slot and an electrical connection is made.
